# EUROPEAN PATENT APPLICATION

(11) **EP 4 583 648 A1**
(43) Date of publication of application: **09.07.2025**
(21) Application number: 23935016.8
(22) Date of filing: 14.11.2023
(51) Int. Cl.: H05K 7/20

(54) **HEAT EXCHANGE SYSTEM AND ELECTRONIC DEVICE**

(30) Priority: 25.04.2023 CN 202310456750
(71) Applicant: Suzhou Metabrain Intelligent Technology Co., Ltd., Suzhou, Jiangsu 215000 (CN)
(72) Inventor: LI, Jinbo, Suzhou, Jiangsu 215000 (CN); CUI, Ruinan, Suzhou, Jiangsu 215000 (CN)
(74) Representative: von Bülow & Tamada
(86) International application number: PCT/CN2023/131569
(87) International publication number: WO 2024/221848

(57) **Abstract**

The present application belongs to the technical field of electronic devices. Provided in the present application are a heat exchange system and an electronic device. The heat exchange system comprises at least two heat sources, arrangement modes of heating elements and power consumptions of the heating elements included in the heat sources being different; and a heat exchange assembly is mounted on each heat source, heat exchange modes and structures of the heat exchange assemblies mounted on the different heat sources being different. Thus, the heating elements in different arrangement modes and having different power consumptions can achieve heat exchange by means of the heat exchange assemblies having different heat exchange modes and different structures, and the heat sources of different structures can all be adapted to the heat exchange assemblies having different mounting demands, so that a higher fitness between heat exchange demands of the heating elements and heat exchange effects of the heat exchange assemblies can be achieved, thus improving the heat exchange efficiency of the heating elements.

## Description

### CROSS-REFERENCE TO RELATED APPLICATION

The present disclosure claims the priority of Chinese patent application filed on April 25, 2023 before the CNIPA, China National Intellectual Property Administration with the application number of 202310456750.9, and the title of "HEAT EXCHANGE SYSTEM AND ELECTRONIC DEVICE", which is incorporated herein in its entirety by reference.

### FIELD

The present disclosure relates to the field of electronic device technologies, and more particularly to a heat exchange system and an electronic device.

### BACKGROUND

With the accelerating pace of technological innovation in the data center industry, the performance and manufacturing level of data centers and servers have been continuously improved, and more and more products have emerged. According to Moore's Law, the power consumption of server chips is increasing year by year. It is foreseeable that the power consumption of the server chips is getting higher and higher. The high power consumption of the server chips will make it difficult to completely dissipate heat if a traditional air cooling manner is adopted, resulting in local overheating, and further resulting in excessive temperature of the server chips and downtime.

At present, the server chips can be located in different heat sources. Since power consumptions of different heat sources are different, the heat generated by different heat sources is also different, and internal spaces of different heat sources are also different. At present, heat sources usually adopt an air cooling or liquid cooling heat exchange manner to dissipate heat, and heat sources with different power consumptions and different internal spaces usually adopt the same heat exchange manner, which leads to that heat sources with different structures cannot adapt to heat exchange components with different installation requirements, and a degree of matching between heat exchange requirements of heat generating elements and heat exchange effects of the heat exchange components is relatively poor, thereby reducing the heat exchange efficiency of the heat generating elements.

### SUMMARY

In some embodiments of the present disclosure, there is provided a heat exchange system and an electronic device, so as to solve the problem that the heat exchange efficiency of different heat sources is relatively poor in some embodiments of the present disclosure.

In order to solve the above technical problem, in a first aspect, there is provided a heat exchange system in some embodiments of the present disclosure. The heat exchange system includes:
at least two heat sources, where arrangement manners of heat generating elements and power consumptions of the heat generating elements included in each of the at least two heat sources are different; and
a heat exchange component is installed on the heat source, and heat exchange manners and structures of heat exchange components installed on different heat sources are different.

In some embodiments, the at least two heat sources include a first type of heat source, a second type of heat source, a third type of heat source and a fourth type of heat source, where
heat generating elements included in the first type of heat source and heat generating elements included in the third type of heat source are arranged in an ordered distribution, and heat generating elements included in the second type of heat source and heat generating elements included in the fourth type of heat source are arranged in an unordered distribution; and
power consumptions of the heat generating elements included in the first type of heat source and power consumptions of the heat generating elements included in the second type of heat source are greater than or a first value, and power consumptions of the heat generating elements included in the third type of heat source and heat generation amounts of heat generating elements included in the fourth type of heat source are less than the first value.

In some embodiments, in the case where the at least two heat sources include the first type of heat source, a cold plate type heat exchange component is installed on the first type of heat source, where
the first type of heat source includes a plurality of first heat generating elements, and a square cavity enclosed by the plurality of first heat generating elements is a first cavity; and
the cold plate type heat exchange component includes one or more liquid cooling heat conducting sheets and a first liquid cooling plate, where one end of each of the one or more liquid cooling heat conducting sheets extends into the first cavity, the other end of the liquid cooling heat conducting sheet is connected to the first liquid cooling plate, and the first liquid cooling plate is provided with a liquid cooling supply and return pipe.

In some embodiments, in the case where the at least two heat sources include the second type of heat source, a glue filling type heat exchange component is installed on the second type of heat source, where
the glue filling type heat exchange component includes a heat conducting glue, a heat conducting shell and a plurality of first heat conducting pipes; and
the second type of heat source includes a plurality of second heat generating elements, where the heat conducting glue is wrapped around the plurality of second heat generating elements, the heat conducting shell covers the heat conducting glue, and the plurality of first heat conducting pipes are connected to the heat conducting shell for transferring heat transferred from the plurality of second heat generating elements to the heat conducting shell to an exterior of the second type of heat source.

In some embodiments, in the case where the at least two heat sources include the third type of heat source, a heat pipe type heat exchange component is installed on the third type of heat source, where
the third type of heat source includes a plurality of third heat generating elements; and
the heat pipe type heat exchange component includes a plurality of second heat conducting pipes and a first liquid cooling heat conducting plate, where the plurality of second heat conducting pipes are located in a gap between two adjacent third heat generating elements, and ends of the plurality of second heat conducting pipes are connected to the first liquid cooling heat conducting plate.

In some embodiments, in the case where the at least two heat sources include the fourth type of heat source, an air-liquid type heat exchange component is installed on the fourth type of heat source, where
the fourth type of heat source includes a fan and a plurality of fourth heat generating elements, and the air-liquid type heat exchange component is arranged close to the fan; and
the air-liquid type heat exchange component includes a heat exchange housing, heat exchange fins and heat exchange pipelines, where the heat exchange fins are installed in an inner cavity of the heat exchange housing, the heat exchange pipelines are arranged in the heat exchange fins, and the heat exchange pipelines are connected to liquid cooling supply and return pipelines.

In some embodiments, the first liquid cooling plate is located on a side of the plurality of first heat generating elements; and
a plane where the first liquid cooling plate is located is perpendicular to a plane where an installation surface of the plurality of first heat generating elements is located.

In some embodiments, the plurality of first heat generating elements are arranged linearly; and
at least two liquid cooling heat conducting sheets are arranged between the first heat generating elements arranged linearly in every two adjacent rows.

In some embodiments, the plurality of first heat generating elements are arranged linearly; and a portion of each of the at least two liquid cooling heat conducting sheets located in the first cavity encloses an annular structure, and the first heat generating elements arranged linearly in each row are located in a cavity formed by the annular structure.

In some embodiments, an orthographic projection of the first liquid cooling plate on a first plane coincides with an orthographic projection of the plurality of first heat generating elements on the first plane, where the first plane is a plane where an installation surface of the plurality of first heat generating elements is located.

In some embodiments, the plurality of first heat generating elements are arranged linearly; and
a plurality of liquid cooling heat conducting sheets are arranged between the first heat generating elements arranged linearly in every two adjacent rows, and each of the first heat generating elements is closely provided with one of the plurality of liquid cooling heat conducting sheets,
where an orthographic projection of one of the plurality of first heat generating elements on a second plane is at least partially overlapped with an orthographic projection of the liquid cooling heat conducting sheet on the second plane, where the second plane and the first plane are perpendicular to each other.

In some embodiments, an overlapping portion of the orthogonal projection of the liquid cooling heat conducting sheet on the second plane and the overlapping portion of the first heat generating elements on the second plane includes a first heat conducting part and a second heat conducting part, where
the first heat conducting part and the second heat conducting part are connected to form a heat conducting cavity, and the first heat generating elements are located in the heat conducting cavity.

In some embodiments, the glue filling type heat exchange component further includes a second liquid cooling heat conducting plate, where
one end of each of the plurality of first heat conducting pipes is connected to the heat conducting shell, and the other end of the first heat conducting pipe is connected to the second liquid cooling heat conducting plate.

In some embodiments, at least two first heat conducting pipes are connected to an outer wall of the heat conducting shell, and the plurality of first heat conducting pipes are connected to different positions of the second liquid cooling heat conducting plate.

In some embodiments, the heat conducting shell and the second liquid cooling heat conducting plate are arranged at intervals, and the plurality of first heat conducting pipes located between the heat conducting shell and the second liquid cooling heat conducting plate are bent.

In some embodiments, portions of the plurality of first heat conducting pipes connected to the outer wall of the heat conducting shell are arranged at equal intervals.

In some embodiments, portions of the plurality of first heat conducting pipes connected to the second liquid cooling heat conducting plate are staggered from each other.

In some embodiments, the glue filling type heat exchange component further includes a second liquid cooling plate, where
the second liquid cooling plate is wrapped around the heat conducting shell, and the second liquid cooling plate is provided with a liquid cooling supply and return pipe; and
one end of each of the plurality of first heat conducting pipes is connected to the heat conducting shell, and the other end of the first heat conducting pipe is wrapped around the second liquid cooling plate.

In some embodiments, portions of the plurality of first heat conducting pipes wrapped around the second liquid cooling plate are arranged at equal intervals.

In some embodiments, the plurality of third heat generating elements are arranged linearly; and
at least two second heat conducting pipes are arranged between the heat generating elements arranged linearly in every two adjacent rows.

In some embodiments, the plurality of third heat generating elements are arranged linearly; and
each of the plurality of second heat conducting pipes is enclosed in an annular structure, and the third heat generating elements arranged linearly in each row are located in a cavity formed by the annular structure.

In some embodiments, the air-liquid type heat exchange component is located on a side of the fan close to the plurality of fourth heat generating elements.

In some embodiments, the air-liquid type heat exchange component is located on a side of the fan away from the plurality of fourth heat generating elements.

In a second aspect, there is further provided an electronic device in some embodiments of the present disclosure. The electronic device includes the heat exchange system according to any one of the embodiments of the first aspect.

As can be seen from the above embodiments, in some embodiments of the present disclosure, since the heat exchange system includes at least two heat sources, where arrangement manners of the heat generating elements and power consumptions of the heat generating elements included in each of the at least two heat sources are different; and the heat exchange component is installed on the heat source, and heat exchange manners and structures of heat exchange components installed on different heat sources are different, the heat generating elements with different arrangement manners and different power consumptions may exchange heat with the heat exchange components with different structures through different heat exchange manners, and heat sources with different structures may adapt to the heat exchange components with different installation requirements, so that the degree of matching between heat exchange requirements of the heat generating elements and heat exchange effects of the heat exchange components is relatively high, thereby improving the heat exchange efficiency of the heat generating elements.

### BRIEF DESCRIPTION OF THE DRAWINGS

In order to more clearly explain the technical solutions in the embodiments of the present disclosure, accompanying drawings that are required to be used in the embodiments or the related art will be briefly introduced below. Obviously, the accompanying drawings described below are merely some embodiments of the present disclosure, and a person skilled in the art may obtain other accompanying drawings according to these accompanying drawings without paying creative labor.
FIG. 1 is a schematic structural diagram of a heat exchange system provided in some embodiments of the present disclosure.
FIG. 2 is a schematic structural diagram of another heat exchange system provided in some embodiments of the present disclosure.
FIG. 3 is a schematic structural diagram of yet another heat exchange system provided in some embodiments of the present disclosure.
FIG. 4 is a schematic structural diagram of still another heat exchange system provided in some embodiments of the present disclosure.
FIG. 5 is a schematic structural diagram of still another heat exchange system provided in some embodiments of the present disclosure.
FIG. 6 is a schematic structural diagram of still another heat exchange system provided in some embodiments of the present disclosure.
FIG. 7 is a schematic structural diagram of still another heat exchange system provided in some embodiments of the present disclosure.
FIG. 8 is a schematic structural diagram of still another heat exchange system provided in some embodiments of the present disclosure.
FIG. 9 is a schematic structural diagram of still another heat exchange system provided in some embodiments of the present disclosure.

Reference numerals:
1: at least two heat sources; 2: heat exchange component; 3: liquid cooling supply and return pipe; 11: first type of heat source; 12: second type of heat source; 13: third type of heat source; 14: fourth type of heat source; 21: cold plate type heat exchange component; 22: glue filling type heat exchange component; 23: heat pipe type heat exchange component; 24: air-liquid type heat exchange component; 111: first heat generating element; 121: second heat generating element; 131: third heat generating element; 141: fourth heat generating element; 142: fan; 211: liquid cooling heat conducting sheet; 212: first liquid cooling plate; 221: heat conducting glue; 222: heat conducting shell; 223: first heat conducting pipe; 224: second liquid cooling heat conducting plate; 225: second liquid cooling plate; 231: second heat conducting pipe; 232: first liquid cooling heat conducting plate.

### DETAILED DESCRIPTION

Technical solutions in some embodiments of the present disclosure will be clearly and completely described below in combination with accompanying drawings. Obviously, the described embodiments are a part of the embodiments of the present disclosure, rather than all of the embodiments. All of the other embodiments that a person skilled in the art obtains on the basis of the embodiments of the present disclosure without paying creative labor fall within the protection scope of the present disclosure.

It should be understood that the term "an embodiment" or "one embodiment" mentioned throughout the specification means that specific features, structures or characteristics related to the embodiments are included in at least one embodiment of the present disclosure. Therefore, the phrase "in an embodiment" or "in one embodiment" that appears in various places throughout the specification may not necessarily refer to the same embodiment. In addition, these specific features, structures or characteristics may be combined in any suitable manner in one or more embodiments.

Before introducing the heat exchange system provided in some embodiments of the present disclosure, the structure of the heat exchange system in the related art will be described as follows.

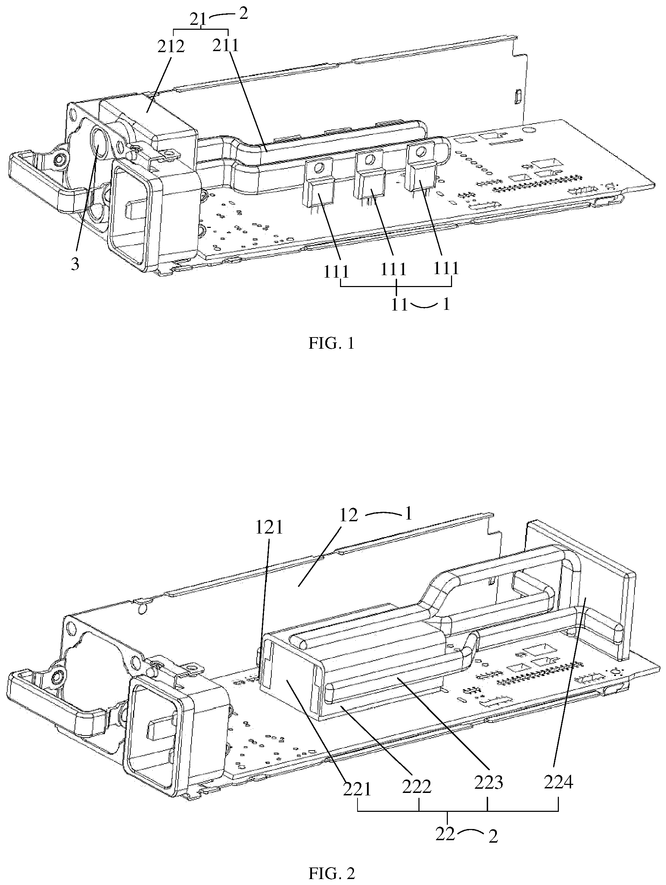

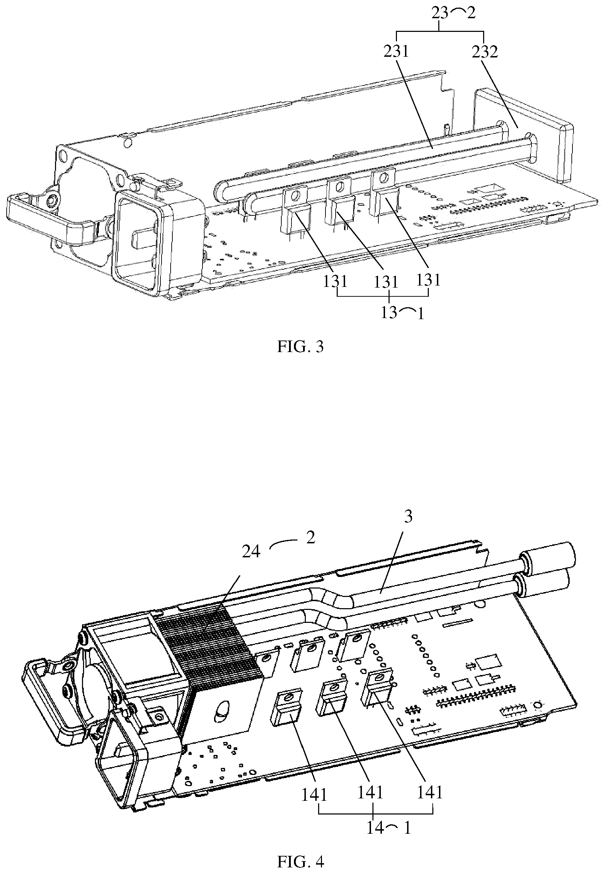

Based on this, in order to solve the above technical problems, FIG. 1 is a schematic structural diagram of a heat exchange system provided in some embodiments of the present disclosure, FIG. 2 is a schematic structural diagram of another heat exchange system provided in some embodiments of the present disclosure, FIG. 3 is a schematic structural diagram of yet another heat exchange system provided in some embodiments of the present disclosure, and FIG. 4 is a schematic structural diagram of still another heat exchange system provided in some embodiments of the present disclosure. As shown in FIG. 1, FIG. 2, FIG. 3 and FIG. 4, in a first aspect, there is provided a heat exchange system in some embodiments of the present disclosure. The heat exchange system includes: at least two heat sources 1, where arrangement manners of heat generating elements and power consumptions of the heat generating elements included in each of the at least two heat sources are different; and a heat exchange component 2 is installed on the heat source, and heat exchange manners and structures of heat exchange components 2 installed on different heat sources are different.

It should be noted that the heat source can be a heat generating element with a certain amount of heat, including power supply capacitors, power supply inductors, power supply coils, heat generating chips, and the like, which is not limited in the present disclosure. In addition, in a heat exchange system, there are at least two types of heat sources with different power consumptions, that is, a power supply system includes a variety of devices with different heat generation amounts, for example, the heat generation amount of the heat generating chips is greater than the heat generation amount of power supply inductors, the heat generation amount of the power supply coils is greater than the heat generation amount of the power supply capacitors.

In addition, it should be noted that the arrangement manners of the heat generating elements included in each heat source are also different, that is, the structure of each heat generating element is different, resulting in different installation space occupied by each heat generating element and different arrangement sequences formed after installation of a plurality of heat generating elements. In other words, since the occupied installation space is different and the arrangement sequences formed after the installation of the plurality of heat generating elements are different, the installation space and installation requirements of the heat exchange component 2 installed on each heat source are also different. In this way, in order to make the heat exchange effect of heat generating elements with different arrangement manners and different power consumptions through the heat exchange components 2 not be affected, in some embodiments, it is necessary to make the heat exchange component 2 installed on each heat source be determined according to the arrangement manners of the heat generating elements and the power consumptions of the heat generating elements included in each heat source. In addition, it should be noted that in some embodiments, the arrangement manners of the heat generating elements can be understood as distribution manners of the plurality of heat generating elements inside the heat source, that is, the arrangement manners of the heat generating elements can be regular and orderly, for example, linear arrangement or matrix arrangement. In addition, the arrangement manners of the heat generating elements can also be irregular, which is not limited in the present disclosure.

A heat exchange component 2 is installed on each heat source. It can be understood that each heat source corresponds to one heat exchange component 2. In other words, the heat generating elements with arrangement manners and different power consumptions exchange heat through the heat exchange components 2 with different heat exchange manners and different structures. The heat exchange manner of the heat exchange component 2 can be at least one of a liquid cooling heat exchange manner, an air cooling heat exchange manner or a contact heat exchange manner, which is not limited in the present disclosure.

As can be seen from the above embodiments, in some embodiments, since the heat exchange system includes at least two heat sources 1, where arrangement manners of the heat generating elements and power consumptions of the heat generating elements included in each of the at least two heat sources are different; and the heat exchange component 2 is installed on the heat source, and heat exchange manners and structures of heat exchange components 2 installed on different heat sources are different, the heat generating elements with different arrangement manners and different power consumptions may exchange heat with the heat exchange components 2 with different structures through different heat exchange manners, and heat sources 1 with different structures may adapt to the heat exchange components with different installation requirements, so that the degree of matching between heat exchange requirements of the heat generating elements and heat exchange effects of the heat exchange components 2 is relatively high, thereby improving the heat exchange efficiency of the heat generating elements.

It should be noted that the above heat sources can be classified according to the arrangement manners of the heat generating elements and power consumptions of the heat generating elements, and different heat exchange components 2 are equipped for different heat sources to meet the heat exchange requirements of the heat generating elements with different arrangement manners and different power consumptions. In some embodiments, the heat sources can be classified into high power consumption heat sources and low power consumption heat sources based on the power consumptions of the heat generating elements included in the heat sources, and then the high power consumption heat sources can be classified into low complexity and high power consumption heat sources (the heat generating elements included in the heat source are uniformly arranged according to a certain rule) and high complexity and high power consumption heat sources (the heat generating elements included in the heat source are arranged in an irregular or disordered manner) according to the arrangement manners of the heat generating elements. The low power consumption heat sources are divided into low complexity and low power consumption heat sources (the heat generating elements included in the heat source are uniformly arranged according to a certain rule) and low complexity and high power consumption heat sources (the heat generating elements included in the heat source are arranged in an irregular or disordered manner). Alternatively, the heat sources can be classified according to the arrangement manners of the heat generating elements included in the heat source and then according to the power consumptions of the heat generating elements included in the heat source. In this way, the heat sources can be divided into four categories, namely, high power consumption and low complexity heat sources, high power consumption and high complexity heat sources, low power consumption and low complexity heat sources, and low power consumption and high complexity heat sources, so as to be equipped with heat exchange components 2 with different heat exchange manners and different structures, respectively.

Specifically, in some embodiments, the at least two heat sources 1 include a first type of heat source 11, a second type of heat source 12, a third type of heat source 13 and a fourth type of heat source 14. Heat generating elements included in the first type of heat source 11 and heat generating elements included in the third type of heat source 13 are arranged in an ordered distribution, and heat generating elements included in the second type of heat source 12 and heat generating elements included in the fourth type of heat source 14 are arranged in an unordered distribution; and power consumptions of the heat generating elements included in the first type of heat source 11 and power consumptions of the heat generating elements included in the second type of heat source 12 are greater than or a first value, and power consumptions of the heat generating elements included in the third type of heat source 13 and heat generation amounts of heat generating elements included in the fourth type of heat source 14 are less than the first value.

It should be noted that since the heat generating elements included in the first type of heat source 11 and heat generating elements included in the third type of heat source 13 are arranged in an ordered distribution, and heat generating elements included in the second type of heat source 12 and heat generating elements included in the fourth type of heat source 14 are arranged in an unordered distribution, and power consumptions of the heat generating elements included in the first type of heat source 11 and power consumptions of the heat generating elements included in the second type of heat source 12 are greater than or a first value, and power consumptions of the heat generating elements included in the third type of heat source 13 and heat generation amounts of heat generating elements included in the fourth type of heat source 14 are less than the first value, heat exchange components 2 with different heat exchange manners and different structures can be equipped based on the first type of heat source 11, the second type of heat source 12, the third type of heat source 13 and the fourth type of heat source 14, respectively. The first value can be a heat generation amount of a heat generating element with a power consumption of 30 watt hours under a same working condition, a heat generation amount of a heat generating element with a power consumption of 40 watt hours under a same working condition, or a heat generation amount of a heat generating element with a power consumption of any value between 30 watt hours and 40 watt hours under a same working condition, and the specific value is determined according to working conditions of the heat source and the heat exchange requirements, which is not limited in the present disclosure.

It should also be noted that when different heat sources are equipped with the heat exchange components 2 with different heat exchange manners and different structures, it can be reasonably equipped according to the heat exchange principle and heat exchange effect of the heat exchange component 2. For example, when performing heat exchange on the low complexity and high power consumption heat sources, it is necessary to select a heat exchange component 2 with relatively high heat exchange efficiency and relatively high installation environment requirements. When performing heat exchange on the high complexity and high power consumption heat sources, it is necessary to select a heat exchange component 2 with relatively high heat exchange efficiency and relatively low installation environment requirements. When performing heat exchange on the low complexity and low power consumption heat sources, it is necessary to select a heat exchange component 2 with relatively low heat exchange efficiency and relatively high installation environment requirements. When performing heat exchange on the high complexity and low power consumption heat sources, it is necessary to select a heat exchange component 2 with relatively low heat exchange efficiency and relatively low installation environment requirements.

In addition, in some embodiments, the heat exchange component 2 with relatively low heat exchange efficiency can select one or more of the heat exchange component 2 with the air cooling heat exchange manner or the heat exchange component 2 with the liquid cooling heat exchange manner, and the heat exchange component 2 with relatively high heat exchange efficiency can select one or more of the heat exchange component 2 with the contact heat exchange manner or the heat exchange component 2 with the liquid cooling heat exchange manner. The heat exchange component 2 with relatively high installation environment requirements can select one or more of the heat exchange component 2 with the contact heat exchange manner or the heat exchange component 2 with the air cooling heat exchange manner, and the heat exchange component 2 with relatively low installation environment requirements can select one or more of the heat exchange component 2 with the air cooling heat exchange manner or the heat exchange component 2 with the liquid cooling heat exchange manner, which is not limited in the present disclosure.

The structures and heat exchange manners of the heat exchange components 2 corresponding to the first type of heat source 11, the second type of heat source 12, the third type of heat source 13 and the fourth type of heat source 14 will be described as follows.

In a first possible implementation manner, as shown in FIG. 1, FIG. 5, FIG. 6 and FIG. 7, in the case where the at least two heat sources 1 include the first type of heat source 11, a cold plate type heat exchange component 21 is installed on the first type of heat source 11. The first type of heat source 11 includes a plurality of first heat generating elements 111, and a square cavity enclosed by the plurality of first heat generating elements 111 is a first cavity; and the cold plate type heat exchange component 21 includes one or more liquid cooling heat conducting sheets 211 and a first liquid cooling plate 212. One end of each of the one or more liquid cooling heat conducting sheets 211 extends into the first cavity, and the other end of the liquid cooling heat conducting sheet 211 is connected to the first liquid cooling plate 212. The first liquid cooling plate 212 is provided with a liquid cooling supply and return pipe 3.

It should be noted that the plurality of first heat generating elements 111 included in the first type of heat source 11 can be arranged according to certain rules, for example, two rows and three columns, two rows and four columns or other matrix distribution forms, so that a square cavity can be enclosed among the plurality of first heat generating elements 111. In this way, one end of the liquid cooling heat conducting sheet 211 can extend into the first cavity and be closely attached to the first heat generating elements 111 around the cavity, so that heat generated by the first heat generating elements 111 can be transferred to the liquid cooling heat conducting sheet 211. In addition, since the other end of the liquid cooling heat conducting sheet 211 is connected to the first liquid cooling plate 212, the heat transferred to the first liquid cooling plate 212 can be cooled by the first liquid cooling plate 212. The principle of the first liquid cooling plate 212 refers to a liquid cooling manner of exchanging heat with the heat generating elements by circulating liquid through a heat exchange plate. The first liquid cooling plate 212 can include the heat exchange plate, the liquid cooling supply and return pipe 3 and a pump. The heat exchange plate is a core component of the first liquid cooling plate 212. The heat exchange plate is connected to the one or more liquid cooling heat conducting sheets 211 to transfer the heat transferred from the one or more liquid cooling heat conducting sheets 211 to the first liquid cooling plate 212 to the liquid by circulating liquid through the heat exchange plate, and then the heat is taken away by the liquid cooling supply and return pipe 3. In this way, when performing heat exchange on the first type of heat source 11 through the above manner, only the one or more liquid cooling heat conducting sheets 211 need to be located in the first cavity enclosed by the plurality of first heat generating elements 111, which may be adapted to the plurality of first heat generating elements 111 with a relatively regular distribution, thereby simplifying the structure of the heat exchange component 2 and reducing the manufacturing and installation cost of the heat exchange component 2 while meeting the heat exchange requirements of the first type of heat source 11. In addition, since the first liquid cooling plate 212 is connected to the one or more liquid cooling heat conducting sheets 211, the heat transferred in the one or more liquid cooling heat conducting sheets 211 is taken away by the liquid cooling manner, thereby meeting the heat exchange requirements of high heat generation amount generated by the plurality of first heat generating elements 111 under the condition of high power consumption.

In addition, it should be noted that the installation position of the first liquid cooling plate 212 can be determined according to the internal structure of the first type of heat source 11. The first liquid cooling plate 212 can be located on a side of the plurality of first heat generating elements 111 or on the top of the plurality of first heat generating elements 111, which is not limited in the present disclosure. In addition, the liquid cooling heat conducting sheet 211 can be a sheet-like heat conducting structure with a liquid cooling pipeline inside, and can circulate with the liquid of the liquid cooling plate, thereby accelerating the heat exchange with the plurality of first heat generating elements 111. The structures and arrangement positions of the one or more liquid cooling heat conducting sheets are determined according to the arrangement position of the first liquid cooling plate 212 and the positions of the plurality of first heat generating elements 111.

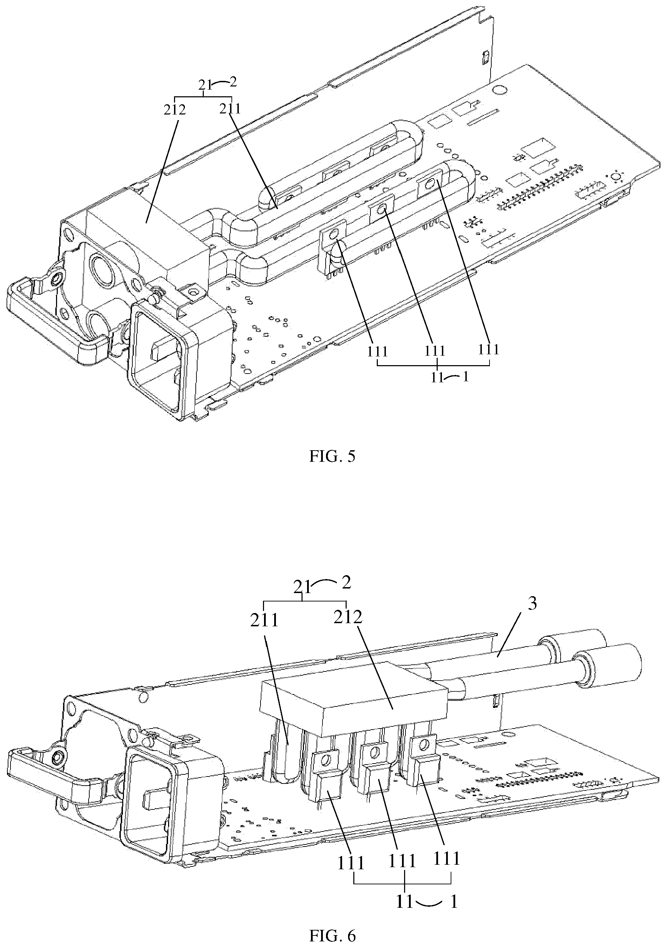

Further, in some embodiments, as shown in FIG. 1 and FIG. 5, the first liquid cooling plate 212 is located on a side of the plurality of first heat generating elements 111, and a plane where the first liquid cooling plate 212 is located is perpendicular to a plane where an installation surface of the plurality of first heat generating elements 111 is located. In some embodiments, the first liquid cooling plate 212 is located on a side surface of the plurality of first heat generating elements 111, and the heat is transferred through the one or more liquid cooling heat conducting sheets 211 connected to the first liquid cooling plate 212 to meet the installation requirements of the cold plate type heat exchange component 21 when the installation space in a direction perpendicular to the plane where the installation surface of the plurality of first heat generating elements 111 is located is limited.

In this embodiment, the plurality of first heat generating elements 111 are arranged linearly; and at least two liquid cooling heat conducting sheets 211 are arranged between the first heat generating elements 111 arranged linearly in every two adjacent rows.

It should be noted that the plurality of first heat generating elements 111 are arranged in a linear manner, for example, two rows and three columns, three rows and three columns, or other linear arrangement manners, so that there is a cavity between the first heat generating elements 111 arranged linearly in every two adjacent rows for installing the one or more liquid cooling heat conducting sheets 211. The number of liquid cooling heat conducting sheets 211 arranged between the first heat generating elements 111 arranged linearly in every two adjacent rows can be any number of one, two, three, or the like, which is not limited in the present disclosure. In this way, since at least two liquid cooling heat conducting sheets 211 are arranged between the first heat generating elements 111 arranged linearly in every two adjacent rows, there is a liquid cooling heat conducting sheet 211 closely attached to the first heat generating elements 111 arranged linearly in each row, which is more conducive to the rapid transfer of heat generated by the first heat generating elements 111 to the liquid cooling heat conducting sheet 211. In addition, it should be noted that if the installation position of the first liquid cooling plate 212 and the installation positions of the liquid cooling heat conducting sheets 211 are not on a same straight line, corners of the liquid cooling heat conducting sheets 211 can be arranged to make the cold plate type heat exchange component 21 adaptable to various installation environments. It should also be noted that in order to ensure the heat exchange effect of the plurality of first heat generating elements 111, it is necessary to make the liquid cooling heat conducting sheets 211 arranged between the first heat generating elements 111 arranged linearly in every two adjacent rows pass through all the first heat generating elements 111 which are opposite to each other. In other words, it is necessary to ensure that the length of the liquid cooling heat conducting sheets 211 arranged between the first heat generating elements 111 arranged linearly in every two adjacent rows is greater than or equal to the column length of the first heat generating elements 111 located in the same column.

In addition, as shown in FIG. 5, in other embodiments, the plurality of first heat generating elements 111 are arranged linearly; and a portion of each of the at least two liquid cooling heat conducting sheets 211 located in the first cavity encloses an annular structure, and the first heat generating elements 111 arranged linearly in each row are located in a cavity formed by the annular structure.

It should be noted that in some embodiments, since the plurality of first heat generating elements 111 are arranged linearly, the portion of each liquid cooling heat conducting sheet 211 located in the first cavity encloses the annular structure, and the first heat generating elements 111 arranged linearly in each row are located in the cavity formed by the annular structure, so that the first heat generating elements 111 arranged linearly in each row may exchange heat in all directions through the liquid cooling heat conducting sheet 211, that is, the relative position between the liquid cooling heat conducting sheet 211 with the first heat generating elements 111 may be located in all directions, which is beneficial to improving the heat exchange efficiency between the liquid cooling heat conducting sheet 211 with the first heat generating elements 111, and further improving the heat exchange efficiency of the cold plate type heat exchange component 21.

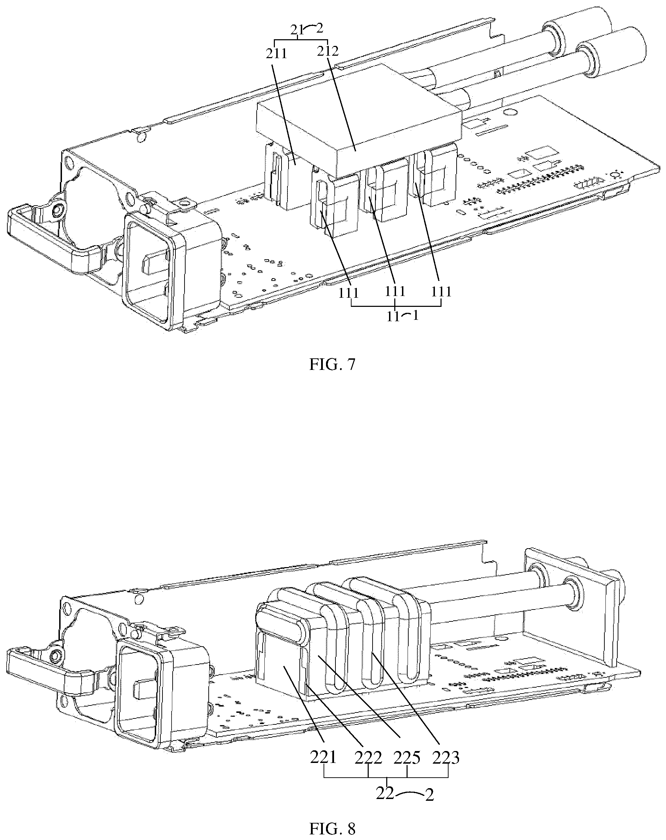

In other embodiments, as shown in FIG. 6 and FIG. 7, an orthographic projection of the first liquid cooling plate 212 on a first plane coincides with an orthographic projection of the plurality of first heat generating elements 111 on the first plane, where the first plane is a plane where an installation surface of the plurality of first heat generating elements 111 is located. In some embodiments, the first liquid cooling plate 212 is located on the top of the plurality of first heat generating elements 111, that is, the first liquid cooling plate 212 covers the plurality of first heat generating elements, and then the heat is transferred through the liquid cooling heat conducting sheets 211 connected to the first liquid cooling plate 212 to meet the installation requirements of the cold plate type heat exchange component 21 when the installation space in a direction parallel to the plane where the installation surface of the plurality of first heat generating elements 111 is located is limited.

In this way, whether the installation space is limited in the direction parallel to the plane where the installation surface of the plurality of first heat generating elements 111 is located or in the direction perpendicular to the plane where the installation surface of the plurality of first heat generating elements 111 is located, the cold plate type heat exchange component 21 may be installed reasonably to meet the installation requirements of different internal installation spaces of the first type of heat source 11, so that the cold plate type heat exchange component 21 may adapt to the installation requirements in different working conditions.

Further, in some embodiments, the plurality of first heat generating elements 111 are arranged linearly; and a plurality of liquid cooling heat conducting sheets 211 are arranged between the first heat generating elements 111 arranged linearly in every two adjacent rows, and each of the first heat generating elements 111 is closely provided with one of the plurality of liquid cooling heat conducting sheets 211, where an orthographic projection of one of the plurality of first heat generating elements 111 on a second plane is at least partially overlapped with an orthographic projection of the liquid cooling heat conducting sheet 211 on the second plane.

It should be noted that since the first liquid cooling plate 212 is located on the top of the first heat generating elements 111, it is necessary to arrange the liquid cooling heat conducting sheets 211 perpendicular to the first plane, even if the plurality of liquid cooling heat conducting sheets 211 are located between the first heat generating elements 111 arranged linearly in every two adjacent rows. In some embodiments, in order to ensure the heat exchange effect of the first heat generating elements 111, it is necessary to make the orthographic projection of one of the first heat generating elements 111 on the second plane is at least partially overlapped with the orthographic projection of the liquid cooling heat conducting sheet 211 on the second plane, that is, each first heat generating element 111 has a liquid cooling heat conducting sheet 211 closely attached to first heat generating element 111. In this way, the heat generated by the first heat generating element 111 corresponding to the liquid cooling heat conducting sheet 211 may be transferred to the first liquid cooling plate 212 through the liquid cooling heat conducting sheet 211 to meet the heat exchange requirements of the plurality of first heat generating elements 111.

It should also be noted that the plurality of first heat generating elements 111 are arranged linearly, which is consistent with the arrangement manner of the first heat generating elements 111 in the above embodiments, and will not be described in detail. The number of liquid cooling heat conducting sheets 211 arranged between the first heat generating elements 111 arranged linearly in every two adjacent rows can be any number of one, two, three, or the like, that is, the number of liquid cooling heat conducting sheets 211 located between two first heat generating elements 111 arranged opposite to each other can be any number of one, two, three, or the like, which is not limited in the present disclosure. In this way, it may be ensured that each first heat generating element 111 has at least one liquid cooling heat conducting sheet 211 closely attached to the first heat generating element 111, which is more conducive to the rapid transfer of heat generated by the first heat generating element 111 to the liquid cooling heat conducting sheet 211. In addition, in order to ensure the heat exchange effect of the plurality of first heat generating elements 111, it is necessary to ensure that the length of the liquid cooling heat conducting sheets 211 arranged between the first heat generating elements 111 arranged linearly in every two adjacent rows is greater than or equal to the size of the first heat generating elements 111 in a direction perpendicular to the first plane.

In some embodiments, as shown in FIG. 7, an overlapping portion of the orthogonal projection of the liquid cooling heat conducting sheet 211 on the second plane and the overlapping portion of the first heat generating elements 111 on the second plane includes a first heat conducting part and a second heat conducting part, where the first heat conducting part and the second heat conducting part are connected to form a heat conducting cavity, and the first heat generating elements 111 are located in the heat conducting cavity.

It should be noted that the first heat conducting part and the second heat conducting part are connected to form the heat conducting cavity, that is, the first heat conducting part and the second heat conducting part can form a U-shaped structure, so that each first heat generating element 111 can be located between the first heat conducting part and the second heat conducting part included in the liquid cooling heat conducting sheet 211, and both sides of each first heat generating element 111 can exchange heat through the liquid cooling heat conducting sheet 211, thereby improving the heat conducting efficiency of the first heat generating element 111. In addition, it should be noted that regardless of the manufacturing cost and manufacturing difficulty of the liquid cooling heat conducting sheet 211, the liquid cooling heat conducting sheet 211 can also be arranged in a cylindrical structure, so that the liquid cooling heat conducting sheet 211 are arranged around the first heat generating elements 111, and a periphery of each first heat generating element 111 can exchange heat through the liquid cooling heat conducting sheet 211.

In a second possible implementation manner, as shown in FIG. 2 and FIG. 8, in the case where the at least two heat sources 1 include the second type of heat source 12, a glue filling type heat exchange component 22 is installed on the second type of heat source 12, where the glue filling type heat exchange component 22 includes a heat conducting glue 221, a heat conducting shell 222 and a plurality of first heat conducting pipes 223; and the second type of heat source 12 includes a plurality of second heat generating elements 121, where the heat conducting glue 221 is wrapped around the plurality of second heat generating elements 121, the heat conducting shell 222 covers the heat conducting glue 221, and the plurality of first heat conducting pipes 223 are connected to the heat conducting shell 222 for transferring heat transferred from the plurality of second heat generating elements 121 to the heat conducting shell 222 to an exterior of the second type of heat source 12.

It should be noted that since the heat generating elements included in the second type of heat source 12 and the and heat generating elements included in the fourth type of heat source 14 are arranged in an unordered distribution, that is, each of the plurality of second heat generating elements 121 has a relatively complex structure, it is not easy to arrange the heat exchange component 2. Based on this situation, in some embodiments, the glue filling type heat exchange component 22 is installed in the second type of heat source 12. In this way, by pouring the heat conducting glue 221 into an area covered by the second heat generating element 121, each portion of the second heat generating element 121 is in contact with the heat conducting glue 221, which is convenient for directly transferring heat to the heat conducting glue 221. Then, the heat conducting shell 222 covers the heat conducting glue 221, and the heat transferred to the heat conducting glue 221 is transferred to the heat conducting shell 222. In addition, since the plurality of first heat conducting pipes 223 are connected to the heat conducting shell 222, the heat transferred from the second heat generating elements 121 to the heat conducting shell 222 can be transferred to the exterior of the second type of heat source 12. It should also be noted that the heat conducting shell 222 can be a regular-shaped shell such as a square shell and a cylindrical shell, or other irregular-shaped shells, which is not limited in the present disclosure. The heat conducting glue 221 can be epoxy adhesive, polyurethane adhesive, heat conducting silicone grease and other adhesives with heat conducting performance.

In some embodiments, since the heat conducting glue 221 is wrapped around the plurality of second heat generating elements 121, the heat conducting shell 222 covers the heat conducting glue 221, and the plurality of first heat conducting pipes 223 are connected to the heat conducting shell 222, the installation of the glue filling type heat exchange component 22 is not limited by the arrangement manner of the plurality of second heat generating elements 121, thereby meeting the relatively complex installation environment inside the second type of heat source 12. In addition, since the heat conducting glue 221 is directly wrapped around the plurality of second heat generating elements 121, the plurality of second heat generating elements 121 are in direct contact with the heat conducting glue 221, thereby simplifying the structure of the glue filling type heat exchange component 22 and reducing the manufacturing and installation cost of the heat exchange component 2 while meeting the relatively complex installation environment of the second type of heat source 12, In addition, the heat generated by the plurality of second heat generating elements 121 may be led out through the heat conducting glue 221, thereby meeting the heat exchange requirements of high heat generation amount generated by the plurality of second heat generating elements 121 under the condition of high power consumption.

Further, in some embodiments, as shown in FIG. 2, the glue filling type heat exchange component 22 further includes a second liquid cooling heat conducting plate 224, where one end of each of the plurality of first heat conducting pipes 223 is connected to the heat conducting shell 222, and the other end of the first heat conducting pipe 223 is connected to the second liquid cooling heat conducting plate 224.

It should be noted that in some embodiments, the second liquid cooling heat conducting plate 224 can include a heat exchange plate and heat exchange pipes, where the heat exchange pipes are distributed inside the heat exchange plate, and the heat exchange pipes are provided with heat exchange liquid. In practical applications, the second liquid cooling heat conducting plate 224 can be in contact with a liquid cooling plate or liquid cooling pipelines of an external device to cool the liquid in the heat exchange pipes, and thus it is possible to exchange heat with the second type of heat source 12 without water. In this way, when heat is generated by the second heat generating elements 121, the heat can be transferred to the heat conducting shell 222 through the heat conducting glue 221, and then transferred to the second liquid cooling heat conducting plate 224 through the plurality of first heat conducting pipes 223 connected to the heat conducting shell 222 to exchange the heat through the second liquid cooling heat conducting plate 224, which may not only meet the heat exchange requirements of the second heat generating elements 121 under the condition of high power consumption, but also save the production and manufacturing cost of the glue filling heat exchange component 22.

In some embodiments, at least two first heat conducting pipes 223 are connected to an outer wall of the heat conducting shell 222, and the plurality of first heat conducting pipes 223 are connected to different positions of the second liquid cooling heat conducting plate 224.

It should be noted that the outer wall of the heat conducting shell 222 can be provided with any number of first heat conducting pipes 223, for example, two first heat conducting pipes 223, three first heat conducting pipes 223, or four first heat conducting pipes 223. The number of first heat conducting pipes 223 is determined according to the shape of the heat conducting shell 222 and the heat exchange requirements of the second heat generating elements 121, which is not limited in the present disclosure. For example, in the case where the heat conducting shell 222 has a square shell structure, the heat conducting shell 222 includes three side surfaces which can be used to connect the first heat conducting pipes 223, so that each of the three side surfaces is connected to at least one first heat conducting pipe 223, and thus the connection positions of the first heat conducting pipes 223 on the heat conducting shell 222 are different, and the heat transferred to the heat conducting shell 222 may be transferred through the first heat conducting pipes 223 at different positions, thereby improving the heat exchange efficiency. In this way, since the connection positions of the first heat conducting pipes 223 on the heat conducting shell 222 are different, and the connection positions of the plurality of first heat conducting pipes 223 on the second liquid cooling heat conducting plate 224 are different, not only may the heat transferred to the heat conducting shell 222 be transferred through the first heat conducting pipes 223 at different positions, but also the heat may be transferred to the second liquid cooling heat conducting plate 224 at different positions, which is more conducive to improving the heat exchange efficiency.

It should also be noted that in the case where there is a certain distance between the second liquid cooling heat conducting plate 224 and the metal heat conducting shell 222, that is, the heat conducting shell 222 and the second liquid cooling heat conducting plate 224 are arranged at intervals, the plurality of first heat conducting pipes 223 located between the heat conducting shell 222 and the second liquid cooling heat conducting plate 224 can be bent. In this way, not only may the installation space be saved by the first heat conducting pipes 223 bent between the heat conducting shell 222 and the second liquid cooling heat conducting plate 224, but also the heat conducting area may be extended and increased by the first heat conducting pipes 223 bent between the heat conducting shell 222 and the second liquid cooling heat conducting plate 224, thereby improving the heat exchange efficiency.

In some embodiments, portions of the plurality of first heat conducting pipes 223 connected to the outer wall of the heat conducting shell 222 are arranged at equal intervals. In this way, it can be ensured that the portions of the plurality of first heat conducting pipes 223 connected to the outer wall of the heat conducting shell 222 are evenly distributed on the outer wall of the heat conducting shell 222, so that contact points between the first heat conducting pipes 223 with the outer wall of the heat conducting shell 222 are evenly distributed, which is more conducive to conducting heat uniformly at all positions of the heat conducting shell 222, thereby improving the heat exchange efficiency. For example, taking the heat conducting shell 222 as the square shell structure as an example, each of the three side surfaces of the heat conducting shell 222 is provided with one first heat conducting pipe 223 or two first heat conducting pipes 223, and the distance between the first heat conducting pipes 223 arranged on two adjacent side surfaces is equal. In addition, it should be noted that in order to ensure the heat conducting effect of the first heat conducting pipes 223 on the heat conducting shell 222, the size of the portions of the first heat conducting pipes 223 arranged on the heat conducting shell 222 in a first direction should be equal to the size of the outer wall of the heat conducting shell 222 in the first direction, where the first direction is a direction perpendicular to a plane where the second liquid cooling heat conducting plate 224 is located.

In other embodiments, portions of the plurality of first heat conducting pipes 223 connected to the second liquid cooling heat conducting plate 224 are staggered from each other. In this way, it is possible to maximize a ratio between an area formed by the portions of the plurality of first heat conducting pipes 223 connected to the second liquid cooling heat conducting plate 224 and an area of a plate surface of the second liquid cooling heat conducting plate 224, thereby maximizing the contact area between the plurality of first heat conducting pipes 223 with the second liquid cooling heat conducting plate 224, and further improving the heat exchange efficiency between the first heat conducting pipes 223 with the second liquid cooling heat conducting plate 224. For example, taking the heat conducting shell 222 as the square shell structure as an example, the three side surfaces of the heat conducting shell 222 include a first side surface, a second side surface and a third side surface, respectively. The first side surface and the second side surface are arranged opposite to each other, and the third side surface is located between the first side surface and the second side surface. The portion of the first heat conducting pipe 223 extending from the first side surface connected to the second liquid cooling heat conducting plate 224 is arranged parallel to a long side of the second liquid cooling heat conducting plate 224, and the portion of the first heat conducting pipe 223 extending from the second side surface connected to the second liquid cooling heat conducting plate 224 is arranged parallel to the long side of the second liquid cooling heat conducting plate 224, and the portions of the two first heat conducting pipes 223 connected to the second liquid cooling heat conducting plate 224 are arranged away from each other. The portion of the first heat conducting pipe 223 extending from the third side surface connected to the second liquid cooling heat conducting plate 224 is arranged parallel to a short side of the second liquid cooling heat conducting plate 224, and is located between the portions of the above two first heat conducting pipes 223 connected to the second liquid cooling heat conducting plate 224.

In some embodiments, as shown in FIG. 8, the glue filling type heat exchange component 22 further includes a second liquid cooling plate 225, where the second liquid cooling plate 225 is wrapped around the heat conducting shell 222, and the second liquid cooling plate 225 is provided with a liquid cooling supply and return pipe 3; and one end of each of the plurality of first heat conducting pipes 223 is connected to the heat conducting shell 222, and the other end of the first heat conducting pipe 223 is wrapped around the second liquid cooling plate 225.

It should be noted that since the second liquid cooling plate 225 is wrapped around the heat conducting shell 222, the second liquid cooling plate 225 is provided with the liquid cooling supply and return pipe 3, one end of each of the plurality of first heat conducting pipes 223 is connected to the heat conducting shell 222, and the other end of the first heat conducting pipe 223 is wrapped around the second liquid cooling plate 225, the heat generated by the second heat generating elements 121 may be transferred to the heat conducting shell 222 through the heat conducting glue 221, and then transferred to the second liquid cooling plate 225 through the first heat conducting pipe 223. The principle of the second liquid cooling plate 225 refers to a method of exchanging heat with the heat generating elements by circulating liquid through the heat exchange plate. The second liquid cooling plate 225 can include the heat exchange plate, the liquid cooling supply and return pipe 3 and the pump. The heat exchange plate is a core component of the second liquid cooling plate 225. The heat exchange plate is connected to the one or more liquid cooling heat conducting sheets 211 to transfer the heat transferred from the one or more liquid cooling heat conducting sheets 211 to the second liquid cooling plate 225 to the liquid by circulating liquid through the heat exchange plate, and then the heat is taken away by the liquid cooling supply and return pipe 3. In this way, since the second liquid cooling plate 225 exchanges heat through the liquid cooling manner, the heat exchange efficiency is higher. Therefore, by transferring the heat transferred to the first heat conducting pipes 223 to the second liquid cooling plate 225, the heat can be quickly dissipated through the liquid cooling plate, which may further meet the heat exchange requirements of the second heat generating elements 121 under the condition of higher energy consumption. In addition, it should be noted that since the second liquid cooling plate 225 is wrapped around the heat conducting shell 222, one end of the first heat conducting pipe 223 is connected to the heat conducting shell 222, and the other end of the first heat conducting pipe 223 is wrapped around the second liquid cooling plate 225, a main body portion of the whole glue filling heat exchange component 22 is an integral structure, which is more conducive to saving the installation space required by the glue filling heat exchange component 22 and facilitating for the installation of the glue filling heat exchange component 22.

In some embodiments, portions of the plurality of first heat conducting pipes 223 wrapped around the second liquid cooling plate 225 are arranged at equal intervals. In this way, not only may contact portions between the first heat conducting pipes 223 and the second liquid cooling plate 225 be evenly distributed, but also the heat exchange between the first heat conducting pipes 223 with the second liquid cooling plate 225 is facilitated, thereby improving the heat exchange efficiency of the glue filling heat exchange component 22. Moreover, the ratio between an area occupied by the first heat conducting pipes 223 with a surface area of the second liquid cooling plate 225 may be maximized, which is beneficial to the heat exchange efficiency between the first heat conducting pipes 223 with the second liquid cooling plate 225. For example, taking the heat conducting shell 222 as the square shell structure as an example, the three side surfaces of the heat conducting shell 222 include a first side surface, a second side surface and a third side surface, respectively. The first side surface and the second side surface are arranged opposite to each other, and the third side surface is located between the first side surface and the second side surface. Each first heat conducting pipe 223 passes through the second side surface from the first side surface and is wrapped around the third side surface to form a U-shaped tubular structure, thereby maximizing the ratio between the area occupied by the first heat conducting pipe 223 with the surface area of the second liquid cooling plate 225.

In a third possible implementation manner, as shown in FIG. 3, in the case where the at least two heat sources 1 include the third type of heat source 13, a heat pipe type heat exchange component 23 is installed on the third type of heat source 13, where the third type of heat source 13 includes a plurality of third heat generating elements 131; and the heat pipe type heat exchange component 23 includes a plurality of second heat conducting pipes 231 and a first liquid cooling heat conducting plate 232, where the plurality of second heat conducting pipes 231 are located in a gap between two adjacent third heat generating elements 131, and ends of the plurality of second heat conducting pipes 231 are connected to the first liquid cooling heat conducting plate 232.

It should be noted that since the heat generating elements included in the first type of heat source 11 and the heat generating elements included in the third type of heat source 13 are arranged in an ordered distribution, and the heat generating elements included in the second type of heat source 12 and the heat generating elements included in the fourth type of heat source 14 are arranged in an unordered distribution; and the power consumptions of the heat generating elements included in the first type of heat source 11 and the power consumptions of the heat generating elements included in the second type of heat source 12 are greater than or a first value, and the power consumptions of the heat generating elements included in the third type of heat source 13 and the heat generation amounts of heat generating elements included in the fourth type of heat source 14 are less than the first value, and thus the heat exchange efficiency of the heat exchange component 2 required by the third type of heat source 13 is relatively low, and the installation environment requirement of the heat exchange component 2 is relatively low. Based on this, in some embodiments, in the case where at least two heat sources 1 include the third type of heat source 13, the heat pipe type heat exchange component 23 is installed on the third type of heat source 13. The heat pipe type heat exchange component 23 includes the plurality of second heat conducting pipes 231 and the first liquid cooling heat conducting plate 232. The plurality of second heat conducting pipes 231 are located in a gap between two adjacent third heat generating elements 131, and ends of the plurality of second heat conducting pipes 231 are connected to the first liquid cooling heat conducting plate 232. During installation, it is only necessary to ensure that the second heat conducting pipe 231 is closely attached to the third heat generating elements 131, and the heat generated by the third heat generating elements 131 may be transferred to the first liquid cooling heat conducting plate 232 through the second heat conducting pipe 231 to realize the heat dissipation of the third heat generating elements 131. In this way, in some embodiments, since the heat pipe type heat exchange component 23 includes the plurality of second heat conducting pipes 231 and the first liquid cooling heat conducting plate 232, and the plurality of second heat conducting pipes 231 are located in a gap between two adjacent third heat generating elements 131, when the third heat generating elements 131 exchange heat, it is only necessary to install the second heat conducting pipe 231 in the gap between two adjacent third heat generating elements 131 to meet the heat dissipation requirements. The whole heat pipe type heat exchange component 23 has a relatively simple structure, which is beneficial to saving the production and manufacturing cost of the heat pipe type heat exchange component 23 while meeting the heat dissipation requirements of the third heat generating elements 131. In addition, since the end of the second heat conducting pipe 231 is connected to the first liquid cooling heat conducting plate 232, in some embodiments, the heat exchange requirements of the third heat generating elements 131 may be met only by the first liquid cooling heat conducting plate 232, which is beneficial to saving the heat exchange cost while saving the power consumption of the heat exchange component 2.

It should also be noted that the first liquid cooling heat conducting plate 232 can include a heat exchange plate and heat exchange pipes, where the heat exchange pipes are distributed inside the heat exchange plate, and the heat exchange pipes are provided with heat exchange liquid. In practical applications, the first liquid cooling heat conducting plate 232 can be in contact with a liquid cooling plate or liquid cooling pipelines of an external device to cool the liquid in the heat exchange pipes, and thus it is possible to exchange heat with the third type of heat source 13 without water. In addition, the heat exchange pipes can be straight pipes, bent pipes, or other shapes of pipes such as circular pipes, which is not limited in the present disclosure.

In some embodiments, the plurality of third heat generating elements 131 are arranged linearly; and at least two second heat conducting pipes 231 are arranged between the heat generating elements arranged linearly in every two adjacent rows.

It should also be noted that the plurality of third heat generating elements 131 are arranged in a linear manner, for example, two rows and three columns, three rows and three columns, or other linear arrangement manners, so that there is a cavity between the third heat generating elements 131 arranged linearly in every two adjacent rows for installing the one or more second heat conducting pipes 231. The number of liquid cooling heat conducting sheets 211 arranged between the third heat generating elements 131 arranged linearly in every two adjacent rows can be any number of one, two, three, or the like, that is, the number of second heat conducting pipes 231 located between the two third heat generating elements 131 arranged opposite to each other can be any number of one, two, three, or the like, which is not limited in the present disclosure. In this way, it may be ensured that each third heat generating element 131 has at least one second heat conducting pipe 231 closely attached to the third heat generating element 131, which is more conducive to the rapid transfer of heat generated by the third heat generating element 131 to the second heat conducting pipe 231. In addition, in order to ensure the heat exchange effect of the plurality of third heat generating elements 131, it is necessary to ensure that the length of the second heat conducting pipes 231 located between the third heat generating elements 131 arranged linearly in every two adjacent rows should be greater than or equal to the length of the third heat generating elements 131 in a row direction. In addition, it should also be noted that if the installation position of the first liquid cooling heat conducting plate 232 and the installation positions of the second heat conducting pipes 231 are not on the same straight line, corners of the second heat conducting pipes 231 can be arranged to make the heat-pipe heat exchange component 23 adaptable to various installation environments. It should also be noted that in order to ensure the heat exchange effect of the plurality of third heat generating elements 131, it is necessary to make the second heat conducting pipes 231 arranged between the third heat generating elements 131 arranged linearly in every two adjacent rows pass through all the first heat generating elements 111 which are opposite to each other. In other words, it is necessary to ensure that the length of the second heat conducting pipes 231 arranged between the third heat generating elements 131 arranged linearly in every two adjacent rows should be greater than or equal to the column length of the third heat generating elements 131 located in the same column.

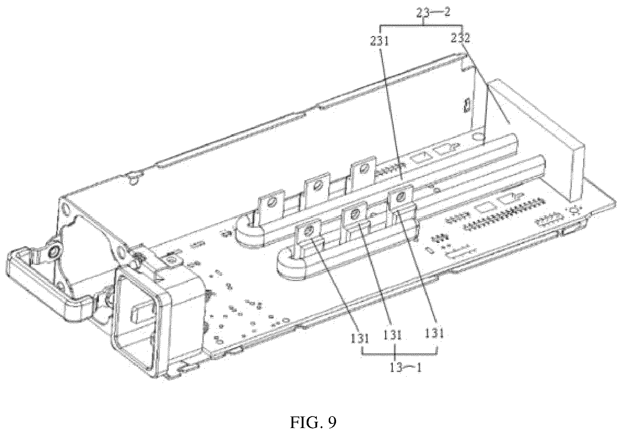

In some embodiments, as shown in FIG. 9, the plurality of third heat generating elements 131 are arranged linearly, each second heat conducting pipe 231 encloses an annular structure, and the third heat generating elements 131 arranged linearly in each row are located in a cavity formed by the annular structure.

It should be noted that in some embodiments, since each second heat conducting pipe 231 encloses the annular structure, and the third heat generating elements 131 arranged linearly in each row are located in the cavity formed by the annular structure, the third heat generating elements 131 arranged linearly in each row may exchange heat in all directions through the second heat conducting pipe 231, that is, the relative position between the second heat conducting pipe 231 with the third heat generating elements 131 may be located in all directions, which is beneficial to improving the heat exchange efficiency between the second heat conducting pipe 231 with the third heat generating elements 131, and further improving the heat exchange efficiency of the heat pipe type heat exchange component 23.

In a fourth possible implementation manner, as shown in FIG. 4, in the case where the at least two heat sources 1 include the fourth type of heat source 14, an air-liquid type heat exchange component 24 is installed on the fourth type of heat source 14, where the fourth type of heat source 14 includes a fan 142 and a plurality of fourth heat generating elements 141, and the air-liquid type heat exchange component 24 is arranged close to the fan; and the air-liquid type heat exchange component 24 includes a heat exchange housing, heat exchange fins and heat exchange pipelines, where the heat exchange fins are installed in an inner cavity of the heat exchange housing, the heat exchange pipelines are arranged in the heat exchange fins, and the heat exchange pipelines are connected to liquid cooling supply and return pipelines 3.

It should be noted that since the heat generating elements included in the first type of heat source 11 and the heat generating elements included in the third type of heat source 13 are arranged in an ordered distribution, and the heat generating elements included in the second type of heat source 12 and the heat generating elements included in the fourth type of heat source 14 are arranged in an unordered distribution; and the power consumptions of the heat generating elements included in the first type of heat source 11 and the power consumptions of the heat generating elements included in the second type of heat source 12 are greater than or a first value, and the power consumptions of the heat generating elements included in the third type of heat source 13 and the heat generation amounts of heat generating elements included in the fourth type of heat source 14 are less than the first value, and thus the heat exchange efficiency of the heat exchange component 2 required by the fourth type of heat source 14 is relatively low, and the installation environment requirement of the heat exchange component 2 is relatively high. Based on this, in some embodiments, in the case where the at least two heat sources 1 include the fourth type of heat source 14, the air-liquid type heat exchange component 24 is installed on the fourth type of heat source 14. Since the fourth type of heat source 14 includes the fan 142 and the plurality of fourth heat generating elements 141, and the air-liquid type heat exchange component 24 is arranged close to the fan 142; and the air-liquid type heat exchange component 24 includes the heat exchange housing, the heat exchange fins and the heat exchange pipelines, where the heat exchange fins are installed in an inner cavity of the heat exchange housing, the heat exchange pipelines are arranged in the heat exchange fins, and the heat exchange pipelines are connected to the liquid cooling supply and return pipelines 3, hot air of the heat generating elements extracted by the fan 142 may be cooled by the air-liquid type heat exchange component 24. In this way, since only the air-liquid type heat exchange component 24 needs to be installed inside the fourth type of heat source 14, the relatively complex installation environment inside the fourth type of heat source 14 may be met. The hot air of the heat generating elements extracted by the fan 142 may be cooled by the air-liquid type heat exchange component 24, and thus the air water heat exchange may be realized, and the heat exchange efficiency of the air-liquid type heat exchange component 24 may be improved to meet the heat exchange requirements at higher temperatures.

It should also be noted that the heat exchange housing included in the air-liquid type heat exchange component 24 can be a square shell, a circular shell, or other shaped shells, and the specific shape of the heat exchange housing is determined according to the internal space of the fourth type of heat source 14, which is not limited in the present disclosure. In addition, the heat exchange fins included in the air-liquid type heat exchange component 24 can be stacked in an inner cavity of the heat exchange housing to increase the heat exchange area of the air-liquid type heat exchange component 24. The heat exchange pipelines connected in the heat exchange fins can be connected to the external liquid cooling supply and return pipelines 3 to cool the liquid in the heat exchange pipelines in the heat exchange fins, so as to achieve the heat exchange effect on the plurality of fourth heat generating elements 141 more quickly. In addition, since the air water heat exchange is used in this embodiment, under the condition that an environment where the fourth type of heat source is located has no fan 142 (for example, an environment where the electronic device including the fourth type of heat source is located has no ventilation devices) and an environment where the fourth type of heat source is located has no air conditioning operation, there is a lack of low-temperature air operation to support heat exchange with the plurality of fourth heat generating elements 141.

In some embodiments, the air-liquid type heat exchange component 24 can be located inside or outside the fourth type of heat source, and the specific installation position of the air-liquid type heat exchange component 24 is determined according to the internal space of the fourth type of heat source, which is not limited in the present disclosure.

In some embodiments, in a possible implementation manner, the air-liquid type heat exchange component 24 is located on a side of the fan 142 close to the plurality of fourth heat generating elements 141.

In some embodiments, when heat generated by the plurality of fourth heat generating elements 141 is extracted by the fan 142, since the air-liquid type heat exchange component 24 is located on the side of the fan 142 close to the plurality of fourth heat generating elements 141, it can be understood that the air-liquid type heat exchange component 24 is located at an air outlet of the fan 142, the heat may be cooled by liquid circulating in the air-liquid type heat exchange component 24, so as to achieve the purpose of quickly dissipating heat from the fourth heat exchange component 2.

In some embodiments, in another possible implementation manner, the air-liquid type heat exchange component 24 is located on a side of the fan 142 away from the plurality of fourth heat generating elements 141.

In some embodiments, when heat generated by the plurality of fourth heat generating elements 141 is extracted by the fan 142, since the air-liquid type heat exchange component 24 is located on the side of the fan 142 away from the plurality of fourth heat generating elements 141, it can be understood that the air-liquid type heat exchange component 24 is located at an air inlet of the fan 142, the heat may be cooled by liquid circulating in the air-liquid type heat exchange component 24, so as to achieve the purpose of quickly dissipating heat from the fourth heat exchange component 2.

It should be noted that regardless of whether the air-liquid type heat exchange component 24 is located on the side of the fan 142 close to the fourth heat generating elements 141 or on the side of the fan 142 away from the fourth heat generating elements 141, the heat generated by the fourth heat generating elements 141 extracted by the fan 142 can be quickly cooled, so as to achieve the purpose of quickly dissipating heat from the fourth heat exchange component.

As can be seen from the above embodiments, in some embodiments, since the heat exchange system includes at least two heat sources 1, where arrangement manners of the heat generating elements and power consumptions of the heat generating elements included in each of the at least two heat sources are different; and the heat exchange component 2 is installed on the heat source, and heat exchange manners and structures of heat exchange components 2 installed on different heat sources are different, the heat generating elements with different arrangement manners and different power consumptions may exchange heat with the heat exchange components 2 with different structures through different heat exchange manners, and heat sources 1 with different structures may adapt to the heat exchange components with different installation requirements, so that the degree of matching between heat exchange requirements of the heat generating elements and heat exchange effects of the heat exchange components 2 is relatively high, thereby improving the heat exchange efficiency of the heat generating elements.

In a second aspect, there is further provided an electronic device in some embodiments of the present disclosure. The electronic device includes the heat exchange system according to any one of the embodiments of the first aspect.

The electronic device can be a mobile electronic device such as a mobile phone, a tablet computer, a notebook computer, a handheld computer, a vehicle-mounted electronic device, a wearable device, an ultra-mobile personal computer (UMPC), a netbook or a personal digital assistant (PDA), and the embodiments of the present disclosure do not specifically limit this.

It should be noted that in the case where the electronic device includes the heat exchange system, since the heat exchange system includes at least two heat sources 1, where arrangement manners of the heat generating elements and power consumptions of the heat generating elements included in each of the at least two heat sources are different; and the heat exchange component 2 is installed on the heat source, and heat exchange manners and structures of heat exchange components 2 installed on different heat sources are different, the heat generating elements with different arrangement manners and different power consumptions may exchange heat with the heat exchange components 2 with different structures through different heat exchange manners, and heat sources 1 with different structures may adapt to the heat exchange components with different installation requirements, so that the degree of matching between heat exchange requirements of the heat generating elements and heat exchange effects of the heat exchange components 2 is relatively high, thereby improving the heat exchange efficiency of the heat generating elements. In this way, the heat dissipation efficiency of the electronic device is improved, partial function damage caused by local overheating of the electronic device is avoided, and the service performance of the electronic device is further improved.

It should be noted that various embodiments in the specification are described in a progressive manner, each embodiment focuses on the difference from other embodiments, and the same and similar parts of various embodiments can be referred to each other.

Although alternative embodiments of the present disclosure have been described, those skilled in the art will be able to make additional changes and modifications to these embodiments once the basic inventive concepts are learned. Therefore, the appended claims are intended be construed to include alternative embodiments and all changes and modifications that fall within the scope of the disclosed embodiments.

Finally, it should be noted that relational terms such as "first" and "second" are used herein merely to distinguish an entity from another entity, and do not necessarily require or imply the existence of any such actual relationship or sequence between these entities. Furthermore, the terms "comprising", "including" or any other variation thereof are intended to cover a non-exclusive inclusion, such that an article or terminal device including a list of elements includes not only those elements but also other elements not expressly listed, or elements inherent to the article or terminal device. Unless being further limited, an element defined by the phrase "comprising a ..." does not exclude the presence of additional identical elements in the article or terminal device including said element.

The technical solutions provided by the present disclosure have been introduced in detail above. Specific examples are used to illustrate the principles and implementation methods of the present disclosure. Moreover, for those skilled in the art, the specific implementation modes and application scope may be changed based on the principles and implementation methods of the present disclosure. In summary, the contents of this description should not be construed as limiting the present disclosure.

## Claims

1. A heat exchange system, comprising:
at least two heat sources, wherein arrangement manners of heat generating elements and power consumptions of the heat generating elements comprised in each of the at least two heat sources are different; and
a heat exchange component is installed on the heat source, and heat exchange manners and structures of heat exchange components installed on different heat sources are different.

2. The heat exchange system according to claim 1, wherein the at least two heat sources comprise a first type of heat source, a second type of heat source, a third type of heat source and a fourth type of heat source, wherein
heat generating elements comprised in the first type of heat source and heat generating elements comprised in the third type of heat source are arranged in an ordered distribution, and heat generating elements comprised in the second type of heat source and heat generating elements comprised in the fourth type of heat source are arranged in an unordered distribution; and
power consumptions of the heat generating elements comprised in the first type of heat source and power consumptions of the heat generating elements comprised in the second type of heat source are greater than or a first value, and power consumptions of the heat generating elements comprised in the third type of heat source and heat generation amounts of heat generating elements comprised in the fourth type of heat source are less than the first value.

3. The heat exchange system according to claim 2, wherein in the case where the at least two heat sources comprise the first type of heat source, a cold plate type heat exchange component is installed on the first type of heat source, wherein
the first type of heat source comprises a plurality of first heat generating elements, and a square cavity enclosed by the plurality of first heat generating elements is a first cavity; and
the cold plate type heat exchange component comprises one or more liquid cooling heat conducting sheets and a first liquid cooling plate, wherein one end of each of the one or more liquid cooling heat conducting sheets extends into the first cavity, the other end of the liquid cooling heat conducting sheet is connected to the first liquid cooling plate, and the first liquid cooling plate is provided with a liquid cooling supply and return pipe.

4. The heat exchange system according to claim 2, wherein in the case where the at least two heat sources comprise the second type of heat source, a glue filling type heat exchange component is installed on the second type of heat source, wherein
the glue filling type heat exchange component comprises a heat conducting glue, a heat conducting shell and a plurality of first heat conducting pipes; and
the second type of heat source comprises a plurality of second heat generating elements, wherein the heat conducting glue is wrapped around the plurality of second heat generating elements, the heat conducting shell covers the heat conducting glue, and the plurality of first heat conducting pipes are connected to the heat conducting shell for transferring heat transferred from the plurality of second heat generating elements to the heat conducting shell to an exterior of the second type of heat source.

5. The heat exchange system according to claim 2, wherein in the case where the at least two heat sources comprise the third type of heat source, a heat pipe type heat exchange component is installed on the third type of heat source, wherein
the third type of heat source comprises a plurality of third heat generating elements; and
the heat pipe type heat exchange component comprises a plurality of second heat conducting pipes and a first liquid cooling heat conducting plate, wherein the plurality of second heat conducting pipes are located in a gap between two adjacent third heat generating elements, and ends of the plurality of second heat conducting pipes are connected to the first liquid cooling heat conducting plate.

6. The heat exchange system according to claim 2, wherein in the case where the at least two heat sources comprise the fourth type of heat source, an air-liquid type heat exchange component is installed on the fourth type of heat source, wherein
the fourth type of heat source comprises a fan and a plurality of fourth heat generating elements, and the air-liquid type heat exchange component is arranged close to the fan; and
the air-liquid type heat exchange component comprises a heat exchange housing, heat exchange fins and heat exchange pipelines, wherein the heat exchange fins are installed in an inner cavity of the heat exchange housing, the heat exchange pipelines are arranged in the heat exchange fins, and the heat exchange pipelines are connected to liquid cooling supply and return pipelines.

7. The heat exchange system according to claim 3, wherein the first liquid cooling plate is located on a side of the plurality of first heat generating elements; and
a plane where the first liquid cooling plate is located is perpendicular to a plane where an installation surface of the plurality of first heat generating elements is located.

8. The heat exchange system according to claim 7, wherein the plurality of first heat generating elements are arranged linearly; and
at least two liquid cooling heat conducting sheets are arranged between the first heat generating elements arranged linearly in every two adjacent rows.

9. The heat exchange system according to claim 7, wherein the plurality of first heat generating elements are arranged linearly; and
a portion of each of the at least two liquid cooling heat conducting sheets located in the first cavity encloses an annular structure, and the first heat generating elements arranged linearly in each row are located in a cavity formed by the annular structure.

10. The heat exchange system according to claim 3, wherein an orthographic projection of the first liquid cooling plate on a first plane coincides with an orthographic projection of the plurality of first heat generating elements on the first plane, wherein the first plane is a plane where an installation surface of the plurality of first heat generating elements is located.

11. The heat exchange system according to claim 10, wherein the plurality of first heat generating elements are arranged linearly; and
a plurality of liquid cooling heat conducting sheets are arranged between the first heat generating elements arranged linearly in every two adjacent rows, and each of the first heat generating elements is closely provided with one of the plurality of liquid cooling heat conducting sheets,
wherein an orthographic projection of one of the plurality of first heat generating elements on a second plane is at least partially overlapped with an orthographic projection of the liquid cooling heat conducting sheet on the second plane, wherein the second plane and the first plane are perpendicular to each other.

12. The heat exchange system according to claim 11, wherein an overlapping portion of the orthogonal projection of the liquid cooling heat conducting sheet on the second plane and the overlapping portion of the first heat generating elements on the second plane comprises a first heat conducting part and a second heat conducting part, wherein
the first heat conducting part and the second heat conducting part are connected to form a heat conducting cavity, and the first heat generating elements are located in the heat conducting cavity.

13. The heat exchange system according to claim 4, wherein the glue filling type heat exchange component further comprises a second liquid cooling heat conducting plate, wherein
one end of each of the plurality of first heat conducting pipes is connected to the heat conducting shell, and the other end of the first heat conducting pipe is connected to the second liquid cooling heat conducting plate.

14. The heat exchange system according to claim 13, wherein at least two first heat conducting pipes are connected to an outer wall of the heat conducting shell, and the plurality of first heat conducting pipes are connected to different positions of the second liquid cooling heat conducting plate.

15. The heat exchange system according to claim 13, wherein the heat conducting shell and the second liquid cooling heat conducting plate are arranged at intervals, and the plurality of first heat conducting pipes located between the heat conducting shell and the second liquid cooling heat conducting plate are bent.

16. The heat exchange system according to claim 14, wherein portions of the plurality of first heat conducting pipes connected to the outer wall of the heat conducting shell are arranged at equal intervals.

17. The heat exchange system according to claim 14, wherein portions of the plurality of first heat conducting pipes connected to the second liquid cooling heat conducting plate are staggered from each other.

18. The heat exchange system according to claim 4, wherein the glue filling type heat exchange component further comprises a second liquid cooling plate, wherein
the second liquid cooling plate is wrapped around the heat conducting shell, and the second liquid cooling plate is provided with a liquid cooling supply and return pipe; and
one end of each of the plurality of first heat conducting pipes is connected to the heat conducting shell, and the other end of the first heat conducting pipe is wrapped around the second liquid cooling plate.

19. The heat exchange system according to claim 18, wherein portions of the plurality of first heat conducting pipes wrapped around the second liquid cooling plate are arranged at equal intervals.

20. The heat exchange system according to claim 5, wherein the plurality of third heat generating elements are arranged linearly; and
at least two second heat conducting pipes are arranged between the heat generating elements arranged linearly in every two adjacent rows.

21. The heat exchange system according to claim 5, wherein the plurality of third heat generating elements are arranged linearly; and
each of the plurality of second heat conducting pipes is enclosed in an annular structure, and the third heat generating elements arranged linearly in each row are located in a cavity formed by the annular structure.

22. The heat exchange system according to claim 6, wherein the air-liquid type heat exchange component is located on a side of the fan close to the plurality of fourth heat generating elements.

23. The heat exchange system according to claim 6, wherein the air-liquid type heat exchange component is located on a side of the fan away from the plurality of fourth heat generating elements.

24. An electronic device, comprising the heat exchange system according to any one of claims 1 to 23.
